# EUROPÄISCHE PATENTSCHRIFT

(11) **EP 2 604 983 B1**
(45) Veröffentlichungstag und Bekanntmachung des Hinweises auf die Patenterteilung: **04.01.2023**
(21) Anmeldenummer: 12007706.0
(22) Anmeldetag: 14.11.2012
(51) Int. Cl.: G01F 1/716, G01F 1/58, G01R 33/12, G01R 33/383, H01F 13/00, G01N 24/08, G01R 33/38, G01R 33/3873, G01R 33/563

(54) **Magnetisierungsvorrichtung für ein kernmagnetisches Durchflussmessgerät**
Magnetizing device for a core magnetic flow meter
Dispositif de magnétisation pour un appareil de mesure de débit à noyau magnétique

(30) Priorität: 20.11.2011 DE 102011118839
(43) Veröffentlichungstag der Anmeldung: 19.06.2013
(73) Patentinhaber: Krohne AG, 4019 Basel (CH)
(72) Erfinder: Pors, Jan Teunis Aart, 3262 EK Oud-Beijerland (NL); Hogendoorn, Cornelius Johannes, 4211 BG Spijk (NL); de Graaf, Ariël, 3511 BV Utrecht (NL); Zoeteweij, Marco Leendert, 3344 EP Hendrik-Ido-Ambacht (NL)
(74) Vertreter: Gesthuysen Patentanwälte

(56) Entgegenhaltungen:
- WO-A1-88/08126
- WO-A1-2007/120057
- DE-U1-202010 004 915
- US-A- 4 355 236
- US-A- 5 168 231
- US-A1- 2008 174 309
- US-B2- 7 884 605

## Beschreibung

Die Erfindung betrifft eine Magnetisierungsvorrichtung zur Durchsetzung eines ein Messrohr eines kernmagnetischen Durchflussmessgeräts durchströmenden mehrphasigen Fluids mit einem zumindest in einer Ebene homogenen Magnetfeld mit einer Mehrzahl an Permanentmagneten zur Erzeugung des Magnetfelds.

Ein kernmagnetisches Durchflussmessgerät bestimmt den Durchfluss der einzelnen Phasen des mehrphasigen Fluids, die Strömungsgeschwindigkeiten der einzelnen Phasen und die relativen Anteile der einzelnen Phasen am mehrphasigen Fluid in dem Messrohr durch Messung und Auswertung der von der kernmagnetischen Resonanz des mehrphasigen Fluids in einen geeigneten Sensor induzierten Spannung. Das Messprinzip der kernmagnetischen Resonanz, im Englischen wird kernmagnetische Resonanz als Nuclear Magnetic Resonance bezeichnet, beruht auf der Eigenschaft von Atomkernen mit einem freien magnetischen Moment, dem Kernspin, in Anwesenheit eines Magnetfeldes zu präzessieren. Die Präzession des das magnetische Moment eines Atomkerns repräsentierenden Vektors erfolgt um den das Magnetfeld an der Stelle des Atomkerns repräsentierenden Vektor, wobei die Präzession eine Spannung in den Sensor induziert. Die Frequenz der Präzession wird als Larmorfrequenz *ω_{L}* bezeichnet und berechnet sich gemäß *ω_{L}* = *γ*·*B*, wobei *γ* das gyromagnetische Verhältnis und B der Betrag der Magnetfeldstärke ist. Das gyromagnetische Verhältnis *γ* ist für Wasserstoffkerne maximal, weshalb insbesondere Fluide mit Wasserstoffkernen für kernmagnetische Durchflussmessgeräte geeignet sind.

Aus Ölquellen wird ein mehrphasiges Fluid, bestehend im Wesentlichen aus Rohöl, Erdgas und Salzwasser gefördert. Sogenannte Testseparatoren zweigen einen kleinen Teil des geförderten Fluids ab, trennen die einzelnen Phasen des Fluids voneinander und bestimmen die Anteile der einzelnen Phasen an dem Fluid. Testseparatoren sind kostenintensiv, können nicht unterseeisch installiert werden und erlauben keine zeitnahen Messungen. Insbesondere sind Testseparatoren aber nicht imstande, Rohölanteile kleiner als 5 % zuverlässig zu messen. Da der Rohölanteil einer jeden Quelle stetig absinkt und der Rohölanteil einer Vielzahl von Quellen bereits geringer als 5 % ist, ist es derzeit nicht möglich, diese Quellen auszubeuten.

Sowohl Rohöl als auch Erdgas und Salzwasser enthalten Wasserstoffkerne, für welche, wie bereits erwähnt, das gyromagnetische Verhältnis *γ* maximal ist. Kernmagnetische Durchflussmessgeräte sind daher besonders für den Einsatz an Ölquellen, auch unterseeisch unmittelbar an der Quelle am Meeresgrund, geeignet, aber nicht auf diese Anwendung beschränkt. Andere Anwendungen eröffnen sich beispielsweise in der petrochemischen oder der chemischen Industrie. Ein Abzweigen des Fluids ist nicht erforderlich, vielmehr wird das gesamte Fluid zeitnah gemessen. Im Vergleich zu Testseparatoren sind kernmagnetische Durchflussmessgeräte kostengünstiger und wartungsärmer und können insbesondere auch Rohölanteile geringer als 5% im Fluid zuverlässig messen, wodurch die - weitere - Ausbeutung einer Vielzahl von Ölquellen erst möglich wird.

Aus der Gleichung zur Berechnung der Larmorfrequenz *ω_{L}* ist unmittelbar ersichtlich, dass die Larmorfrequenz *ω_{L}* proportional zur Magnetfeldstärke *B* ist und somit die Magnetfeldstärke *B* auch unmittelbar auf die in den Sensor induzierte Spannung wirkt. Inhomogenitäten im Magnetfeld reduzieren daher die Messqualität von kernmagnetischen Durchflussmessgeräten, weshalb die Aufgabe der Magnetisierungsvorrichtung die Durchsetzung des Fluids mit einem im inneren des Messrohrs für gewöhnlich homogenen Magnetfeld ist. Die erforderliche Messgenauigkeit bestimmt die notwendige Homogenität des Magnetfelds. Oftmals kommen Messverfahren zum Einsatz, die einen bekannten Gradienten im Magnetfeld ausnutzen, so dass das Magnetfeld nur in einer Ebene konstant ist.

Eine gattungsgemäße Magntisierungsvorrichtung ist aus der WO 2007/120057 bekannt.

Weiter ist aus der amerikanischen Offenlegungsschrift 2008/0174309 eine Magnetisierungsvorrichtung aus einem einen hohlzylinderförmigen Permanentmagneten bildenden Stapel von Scheibenmagneten bekannt, wobei das Magnetfeld im zylinderförmigen Innenraum der Magnetisierungsvorrichtung homogen ist, der Stapel eine Mehrzahl von Scheibenmagneten umfasst und die Scheibenmagneten durch Schrauben aus einem nichtmagnetischen Material fixiert sind. Zu jedem der Scheibenmagneten gehört eine Mehrzahl von rechteckigen Stabmagneten, wobei die Stabmagneten zwischen jeweils zwei Scheiben aus einem nichtmagnetischen Material in als formschlüssigen Vertiefungen ausgebildeten Magnetaufnahmen angeordnet und durch Schrauben aus einem nichtmagnetischen Material fixiert sind.

Diese Magnetisierungsvorrichtung bestehen aus einer Vielzahl von Scheibenmagneten. In jedem einzelnen der Scheibenmagneten sind eine Vielzahl von Stabmagneten zu einem Halbach-Array angeordnet. Das wesentliche Merkmal eines Halbach-Arrays ist, dass das Magnetfeld sich überwiegend auf einer Seite des Halbach-Arrays ausbildet, hier in dem Innenraum der zylinderförmigen Magnetisierungsvorrichtung, und auf einer anderen Seite sich ein nur sehr schwaches Magnetfeld ausbildet, hier in dem Außenraum der zylinderförmigen Magnetisierungsvorrichtung. Da für in den Sensor durch die Präzession der im Fluid enthaltenen Wasserstoffatome hohe induzierte Spannungen ein starkes Magnetfeld benötigt wird, kommen entsprechend starke Stabmagneten zum Einsatz. Aufgrund der Mehrzahl von räumlich eng angeordneten Stabmagneten in jeder der Magnetscheiben ist das Einbringen der Stabmagneten in die Magnetaufnahmen mit einem hohen Kraftaufwand verbunden. Darüber hinaus ist das resultierende Magnetfeld einer gattungsgemäßen Magnetisierungsvorrichtung zunächst nicht ausreichend homogen, weshalb das Magnetfeld durch Manipulation an jedem einzelnen der Stabmagneten homogenisiert werden muss. Dieser Prozess wird als Shimming bezeichnet. Das Einbringen und das Shimming der Vielzahl von Stabmagneten bedeutet einen beträchtlichen Produktions- und insbesondere Zeitaufwand, der mit entsprechenden Kosten einhergeht.

Aufgabe der vorliegenden Erfindung ist die Angabe einer Magnetisierungsvorrichtung mit verringerten Produktions- und Zeitaufwand bei weiterhin ausreichender Homogenität des das Fluid durchsetzenden Magnetfelds.

Die erfindungsgemäße Magnetisierungsvorrichtung, bei der die zuvor hergeleitete und aufgezeigte Aufgabe gelöst ist, ist so ausgeführt, dass sie einen Träger aufweist, dass der Träger eine Mehrzahl an Magnetaufnahmen aufweist, jede der Magnetaufnahmen eine Mehrzahl der der Permanentmagneten aufnimmt, die Formgebung der Magnetaufnahmen und der Permanentmagneten eine Bewegung zur Aufnahme der Permanentmagneten in den Magnetaufnahmen nur in einer Richtung zulässt, die von den Magnetaufnahmen aufgenommenen Permanentmagnete durch die Magnetaufnahmen in Bezug auf das Magnetfeld angeordnet sind und dass die Magnetaufnahmen als Hohlprofile ausgebildet sind.

Ein Hohlprofil ist mit verschiedenen, zur Längsachse des Hohlprofils senkrechten inneren Querschnittkonturen und in beliebigen Längen kostengünstig herstellbar. Beispielsweise ist die innere Querschnittkontur eines Hohlprofils rechteckig und eine der äußeren Querschnittkonturen der Permanentmagneten ebenfalls rechteckig und derart dimensioniert, dass die Permanentmagneten entlang nur der Längsachse des Hohlprofils im Hohlprofil bewegbar sind, also formschlüssig mit Ausnahme der Längsachse sind. Die Länge des Hohlprofils in diesem Beispiel ist derart bemessen, dass eine Mehrzahl von Permanentmagneten eingebracht werden kann. Es ist unmittelbar ersichtlich, dass das Fixieren der Permanentmagneten durch das Einschieben der Permanentmagneten in diese Hohlprofile einen wesentlich geringeren Produktions- und Zeitaufwand bedeutet als das aus dem Stand der Technik bekannte Fixieren der Permanentmagneten in einer Mehrzahl von Scheibenmagneten zwischen jeweils zwei Scheiben. Das aufwändige Stapeln der einzelnen Scheibenmagneten wird durch einen einfachen Träger zur Aufnahme der Hohlprofile ersetzt, wobei der Träger die Hohlprofile derart ausrichtet, dass das Fluid von einem ausreichend homogenen Magnetfeld durchsetzt ist.

Bei einer bevorzugten Ausführungsform der erfindungsgemäßen Magnetisierungsvorrichtung ist die Reibung bei der Bewegung zur Aufnahme der Permanentmagneten in den Hohlprofilen durch eine Auskleidung der Hohlprofile reduziert. Beispielsweise kann an den Innenflächen der Hohlprofile eine PTFE-Beschich-tung vorgesehen sein. Durch die reduzierte Reibung wird der Kraftaufwand für das Einbringen der Permanentmagneten in die Hohlprofile deutlich reduziert. Nach dem Einbringen der Permanentmagneten in die Hohlprofile können die Permanentmagneten in den Hohlprofilen durch eine zunächst flüssige und dann aushärtende Substanz fixiert sein. In Frage kommen dafür beispiels-weise Vergussmassen.

Bei einer weiteren bevorzugten Ausführungsform der erfindungsgemäßen Magnetisierungsvorrichtung, weist der Träger eine Mehrzahl von Aufnahmerohren auf. In jedem der Aufnahmerohre ist ein Hohlprofil zur Aufnahme von mindestens einem der Permanentmagneten ausgebildet. Als Material für die Aufnahmerohre bietet sich ein Glasfaserverbundwerkstoff an, da es bei diesem Material auf einfache Weise möglich ist, beispielsweise rechteckige Hohlprofile im Herstellungsprozess auszubilden. In die rechteckigen Hohlprofile können dann Permanentmagneten mit einem üblichen rechteckigen Querschnitt eingebracht werden, so dass sich die Permanentmagneten in dem Hohlprofil nur entlang der Hohlprofillängsachse bewegen, aber nicht um die Hohlprofillängsachse drehen lassen. Als Halterung der Aufnahmerohre kann der Träger wenigstens eine Scheibe mit Aufnahmen für die Aufnahmerohre aufweisen, in der vorzugsweise eine Durchführung für das Messrohr vorgesehen ist. Für gewöhnlich sind die Aufnahmerohre einer Magnetisierungsvorrichtung gleich lang, so dass sich als Halterung der Aufnahmerohre eine derartige Scheibe an jedem Ende der Aufnahmerohre anbietet. Der Träger besteht dann im Wesentlichen aus den Aufnahmerohren und den zwei Scheiben. Soll im Messrohr entlang der Messrohrlängsachse ein homogenes Magnetfeld vorliegen, so bietet sich die zur Messrohrlängsachse parallele Ausrichtung der Aufnahmerohrlängsachsen an. Oftmals werden die Permanentmagnete in den Aufnahmerohren als Halbach Array angeordnet.

In einem weiteren bevorzugten Ausführungsbeispiel der erfindungsgemäßen Magnetisierungsvorrichtung, das eine Weiterbildung des vorausgegangenen Ausführungsbeispiels ist, ist wenigstens eines der Aufnahmerohre teilweise aus einem das Magnetfeld beeinflussenden Material hergestellt. Wird beispielsweise ein Material guter magnetischer Leitfähigkeit in den Aufnahmerohren an den Polen der Permanentmagneten verwendet, so kann das resultierende Magnetfeld damit im Hinblick auf ein homogenes Magnetfeld im Messrohr vorteilhaft beeinflusst werden. Zusätzlich oder alternativ können die Aufnahmerohre zur vorteilhaften Beeinflussung der Homogenität des Magnetfelds im Messrohr um ihre Längsachse drehbar im Träger angeordnet sein und gegen Drehungen fixierbar sein. Das Drehen der Aufnahmerohre ist ein erstes Shimming des Magnetfelds.

In einer weiteren ganz besonders bevorzugten Ausgestaltung der Erfindung umfasst der Träger wenigstens einen Profilkörper, wobei die Profilkörper vorzugsweise Extrusionsprofilkörper sind. Das Querschnittprofil eines jeden der Profilkörper ist konstant entlang der jeweiligen Profilkörperlängsachse und in mindestens einem der Profilkörper ist wenigstens ein Hohlprofil zur Aufnahme von mindestens einem der Permanentmagneten ausgebildet. Vorzugsweise sind auch hier die Hohlprofile derart zur Aufnahme von rechteckigen Permanentmagneten ausgebildet, dass die in einem der Hohlprofile eingebrachten Permanentmagneten zwar entlang der Hohlprofillängsachse bewegbar, aber nicht um die Hohlprofillängsachse drehbar sind. Als Material für die Profilkörper kommen beispielsweise Aluminiumlegierungen oder Keramiken zum Einsatz. Zur Durchsetzung des Messrohrs mit einem homogenen Magnetfeld entlang der Messrohrlängsachse bietet sich wieder eine Ausrichtung der Profilkörperlängsachsen parallel zur Messrohrlängsachse an.

In einer weiteren ganz besonders bevorzugten Ausführungsform der erfindungsgemäßen Magnetisierungsvorrichtung der Erfindung umfasst der Träger wenigstens zwei Profilkörper und jeweils zwei Profilkörper sind lösbar durch mindestens ein positiv ausgeformtes Verbindungsprofil am ersten Profilkörper und mindestens ein negativ ausgeformtes Verbindungsprofil am zweiten Profilkörper verbunden. Das positive und das negative Verbindungsprofil sind derart ausgeformt, dass zwei verbundene Profilkörper eine translatorische Bewegung gegeneinander nur entlang einer Achse ausführen können. Durch diese Art der Verbindung lassen sich die Profilkörper auf einfache Weise beispielsweise um das Messrohr anordnen und so die Magnetisierungsvorrichtung auf einfache Weise installieren.

In einer weiteren besonderen Ausführungsform der erfindungsgemäßen Magnetisierungsvorrichtung ist der wenigstens einen Profilkörper enthaltende Träger als Joch zur Führung des von den Permanentmagneten erzeugten magnetischen Rückflusses ausgebildet. Die Querschnittprofile eines jeden der Profilkörper sind konstant entlang der jeweiligen Profilkörperlängsachse und in wenigstens einem der Profilkörper ist mindestens ein Hohlprofil zur Aufnahme von mindestens einem der Permanentmagneten vorgesehen. Die Führung des magnetischen Rückflusses bietet sich als Alternative zur Anordnung der Permanentmagneten als Halbach-Array an. Als Material zumindest für das Joch bieten sich solche mit hoher magnetischer Leitfähigkeit an.

Im Einzelnen gibt es nun verschiedene Möglichkeiten, die erfindungsgemäße Magnetisierungsvorrichtung auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen
- Fig. 1: ein erstes Ausführungsbeispiel der erfindungsgemäßen Magnetisierungsvorrichtung mit Aufnahmerohren in Explosionsdarstellung,
- Fig. 2: ein zweites Ausführungsbeispiel der erfindungsgemäßen Magnetisierungsvorrichtung mit mehreren drehbaren Aufnahmerohren,
- Fig. 3: ein drittes Ausführungsbeispiel der erfindungsgemäßen Magnetisierungsvorrichtung mit einem Träger aus mehreren Extrusionsprofilkörpern in Explosionsdarstellung und
- Fig. 4: ein viertes Ausführungsbeispiel mit einem Träger aus mehreren Extrusionsprofilkörpern in Explosionsdarstellung.

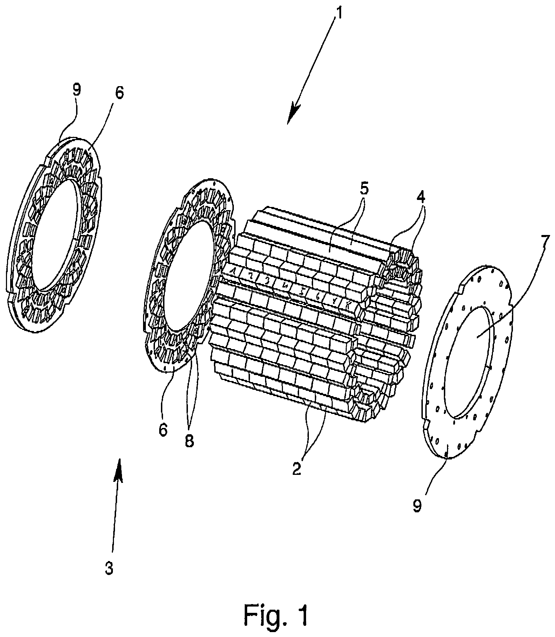

Fig. 1 zeigt die wesentlichen Komponenten einer erfindungsgemäßen Magnetisierungsvorrichtung 1; das sind eine Mehrzahl von Permanentmagneten 2 und ein Träger 3 aus nichtmagnetischem Material. Die hauptsächlichen Komponenten des Trägers 3 sind eine Mehrzahl von als Hohlprofile 4 ausgebildeten Aufnahmerohren 5, zwei Scheibenringe 6 mit einer Durchführung 7 für ein Messrohr und mit Aufnahmen 8 für die Aufnahmerohre 5 und zwei Endscheibenringe 9 ebenfalls mit einer Durchführung 7 für das Messrohr. In der Fig. 1 sind nicht alle Aufnahmerohre 5 sichtbar, um auch die Permanentmagnete 2 zeigen zu können.

In jedem der Aufnahmerohre 5 sind acht gleich lange Permanentmagnete 2 eingebracht, wobei die Querschnittkontur dieser Permanentmagnete 2 rechteckig und formschlüssig mit den Hohlprofilen 4 ist, so dass die Permanentmagnete 2 in einem der Hohlprofile 4 nur entlang der Längsachse des Hohlprofils 4 bewegbar, aber nicht um die Längsachse des Hohlprofils 4 drehbar sind. Die Permanentmagnete 2 lassen sich in Gruppen mit verschieden großen Querschnittflächen einteilen, wodurch die Permanentmagnete 2 unterschiedliche Magnetfeldstärken aufweisen.

Die in den mit den Endscheibenringen 9 verschraubten Scheibenringen 6 vorgesehenen Aufnahmen 8 ordnen die mit den Permanentmagneten 2 bestückten Aufnahmerohre 5 derart um das Messrohr an, dass die Permanentmagnete 2 ein Halbach-Array bilden. Die Aufnahmerohren 5 sind im Wesentlichen in zwei Ringen um das Messrohr arrangiert und werden durch lange, hier nicht eingezeichnete Schrauben fixiert, welche die beiden Endscheibenringe 9 miteinander verbinden und die beiden Endscheibenringe 9 gegeneinander ziehen. Ein aus dem Stand der Technik bekannter Träger benötigt für die gleiche Anordnung der Permanentmagnete 2 sechzehn Scheibenringe 6, zwei Scheibenringe 6 für jeden der acht Ringe aus den Permanentmagneten 2. Der reduzierte Aufwand ist ganz offensichtlich.

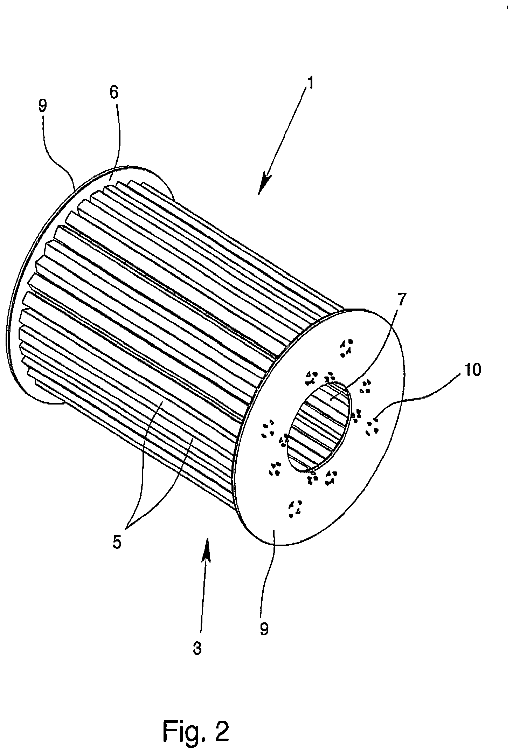

Das in Fig. 2 gezeigte Ausführungsbeispiel der erfindungsgemäßen Magnetisierungsvorrichtung 1 unterscheidet sich von dem in Fig. 1 gezeigten Ausführungsbeispiel im Wesentlichen durch die Drehbarkeit mehrerer Aufnahmerohre 5 um ihre Längsachse. Da die Magnetfeldstärken und -richtungen der einzelnen Permanentmagnete 2 durch den Herstellungsprozess der Permanentmagnete 2 unvermeidbaren Schwankungen unterliegen, kommt es selbst bei einer optimalen Anordnung der Permanentmagnete 2 durch den Träger 3 zu Inhomogenitäten des resultierenden Magnetfelds im Messrohr. Durch die Drehung einzelner Aufnahmerohre 5 können die Inhomogenitäten vermindert werden. Die äußere Querschnittkontur der drehbaren Aufnahmerohre 5 senkrecht zu ihrer Längsachse ist kreisrund und die dazugehörigen Aufnahmen 8 in den Scheibenringen 6 sind entsprechend kreisrund und formschlüssig zu den Aufnahmerohren 5. Zum Drehen und Fixieren ist jedes der drehbaren Aufnahmerohre 5 mit einer Drehvorrichtung 10 ausgestattet. Zu jeder der Drehvorrichtungen 10 gehören zwei gegenüberliegende Stifte zum Drehen und zwei gegenüberliegende Schrauben zum Fixieren des jeweiligen Aufnahmerohrs 5. Entsprechend sind in dem in Fig. 2 vorderen Endscheibenring 9 um die Längsachse eines jeden der drehbaren Aufnahmerohre 5 vier konzentrische Langlöcher vorgesehen.

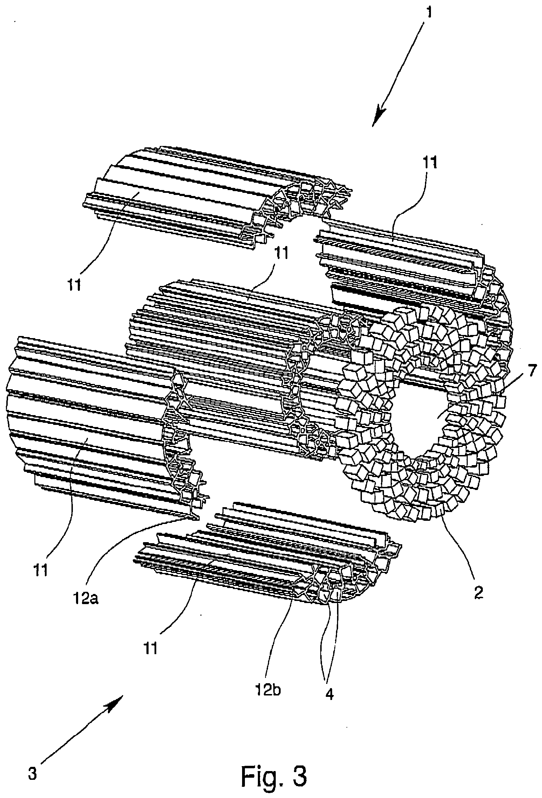

Fig. 3 zeigt eine erfindungsgemäße Magnetisierungsvorrichtung 1 mit dem im Wesentlichen aus mehreren, aus einer Aluminiumlegierung hergestellten Extrusionsprofilkörpern 11 zusammengesetzten Träger 3. Alle Extrusionsprofilkörper 11 haben die gleiche Länge und jeder der Extrusionsprofilkörper 11 weist eine Mehrzahl von Hohlprofilen 4 auf. Die innere Querschnittkontur eines jeden der Hohlprofile 4 senkrecht zu der Längsachse des entsprechenden Hohlprofils 4 ist rechteckig ausgebildet, wobei nicht alle Querschnittkonturen der Extrusionsprofilkörper 11 geschlossen sind. Die nicht geschlossenen Konturen werden im zusammengebauten Zustand durch die anderen Extrusionsprofilkörper 11 geschlossen.

Die Permanentmagnete 2 haben alle die gleiche Länge, so dass in jedes der Hohlprofile 4 die gleiche Anzahl an Permanentmagneten 2 eingebracht ist, und sie lassen sich in Gruppen mit verschieden großen rechteckigen Querschnittflächen senkrecht zu ihrer Längsachse einteilen, wodurch die Permanentmagnete 2 unterschiedliche Magnetfeldstärken aufweisen. Die in eines der Hohlprofile 4 eingebrachten Permanentmagnete 2 sind nicht drehbar um die Längsachse des entsprechenden Hohlprofils 4, wobei die innere Querschnittkontur des Hohlprofils 4 senkrecht zur Längsachse des Hohlprofils 4 nicht gleich der äußeren Querschnittkontur der in das Hohlprofil 4 eingebrachten Permanentmagnete 2 ist.

Im zylinderförmigen Extrusionsprofilkörper 11 ist konzentrisch entlang der Längsachse des zylinderförmigen Extrusionsprofilkörpers 11 eine Durchführung 7 für das Messrohr vorgesehen und die übrigen vier Extrusionsprofilkörper 11 werden rings um den zylinderförmigen Extrusionsprofilkörper 11 angeordnet, so dass die Längsachsen der Hohlprofile 4 parallel zueinander und parallel zur Längsachse des zylinderförmigen Extrusionsprofilkörpers 11 ausgerichtet sind. Die Permanentmagnete 2 sind im Träger 3 derart angeordnet, dass sie ein Halbach-Array bilden.

Von jeweils zwei der Extrusionsprofilkörper 11 weist der erste Extrusionsprofilkörper 11 ein positives Verbindungsprofil 12a und der zweite Extrusionsprofilkörper 11 ein negatives Verbindungsprofil 12b auf. Die äußere Querschnittkontur senkrecht zur Längsachse des positiven Verbindungsprofils 12a und die innere Querschnittkontur senkrecht zur Längsachse des negativen Verbindungsprofils 12b sind formschlüssig und derart ausgebildet, dass im verbundenen Zustand nur eine gegenseitige Bewegung der beiden Extrusionsprofilkörper 11 entlang der Längsachse des positiven Verbindungsprofils 12a möglich ist.

Eine Bewegung der Permanentmagnete 2 in den Hohlprofilen 4 entlang der Längsachse des zylinderförmigen Extrusionsprofilkörpers 11 und eine Bewegung der Extrusionsprofilkörper 11 gegeneinander entlang der Längsachse des zylinderförmigen Extrusionsprofilkörpers 11 ist durch zwei - hier nicht eingezeichnete - Endscheibenringe 9 unterbunden. In jedem der beiden Endscheibenringen 9 ist eine Durchführung für das Messrohr und sind Bohrungen für die Durchführung von Schrauben vorgesehen. Entsprechend sind in den Stirnseiten der Extrusionsprofilkörper 11 Gewinde zum Verschrauben mit den Endscheibenringen 9 vorgesehen.

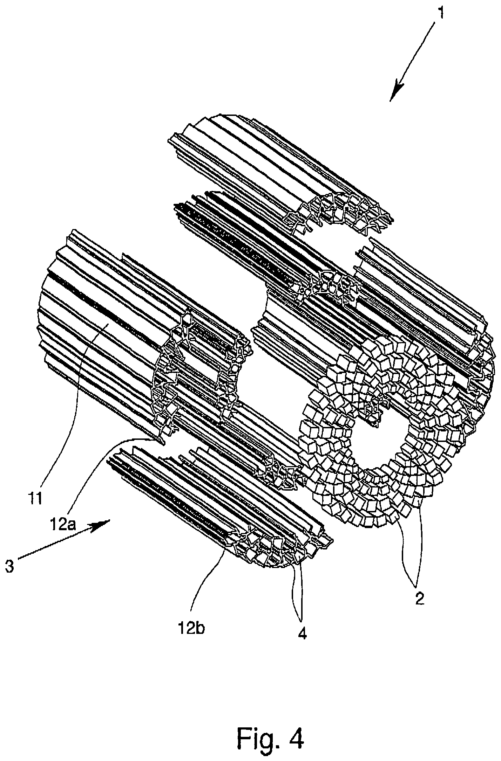

Fig. 4 zeigt eine weitere erfindungsgemäße Magnetisierungsvorrichtung 1 mit dem im Wesentlichen aus mehreren, aus einem Kunststoff im Spritzgussverfahren hergestellten Extrusionsprofilkörpern 11 zusammengesetzten Träger 3. Die Magnetisierungsvorrichtung 1 unterscheidet sich von der in Fig. 3 gezeigten Magnetisierungsvorrichtung 1 im Wesentlichen durch den Ersatz des einteiligen zylinderförmigen Extrusionsprofilkörpers 11 durch einen mehrteiligen Extrusionsprofilkörper 11.

Im Vergleich zu den in Fig. 1 und Fig. 2 gezeigten erfindungsgemäßen Magnetisierungsvorrichtungen 1 ist der Herstellungsaufwand und damit auch der Kostenaufwand bei den in Fig. 3 und Fig. 4 gezeigten Magnetisierungsvorrichtungen 1 nochmals reduziert.

Zuvor ist als zu verwendendes Material teilweise Kunststoff, teilweise Keramik angesprochen worden. Stattdessen kann auch Keramik oder Aluminium verwendet werden.

## Patentansprüche

1. Magnetisierungsvorrichtung (1) zur Durchsetzung eines ein Messrohr eines kernmagnetischen Durchflussmessgeräts durchströmenden mehrphasigen Fluids mit einem zumindest in einer Ebene homogenen Magnetfeld mit einer Mehrzahl an Permanentmagneten (2) zur Erzeugung des Magnetfelds,
**dadurch gekennzeichnet,**
**dass** die Magnetisierungsvorrichtung (1) einen Träger (3) aufweist,
**dass** der Träger (3) eine Mehrzahl an Magnetaufnahmen aufweist, jede der Magnetaufnahmen eine Mehrzahl der Permanentmagneten (2) aufnimmt, die Formgebung der Magnetaufnahmen und der Permanentmagneten (2) eine Bewegung zur Aufnahme der Permanentmagneten (2) in den Magnetaufnahmen nur in einer Richtung zulässt, die von den Magnetaufnahmen aufgenommenen Permanentmagnete (2) durch die Magnetaufnahmen in Bezug auf das Magnetfeld angeordnet sind und
**dass** die Magnetaufnahmen als Hohlprofile (4) ausgebildet sind.

2. Magnetisierungsvorrichtung (1) nach Anspruch 1, **dadurch gekennzeichnet, dass** die Reibung bei der Bewegung zur Aufnahme der Permanentmagneten (2) in den Hohlprofilen (4) durch eine Auskleidung der Hohlprofile (4) reduziert ist.

3. Magnetisierungsvorrichtung (1) nach Anspruch 1 oder 2, **dadurch gekennzeichnet, dass** die Permanentmagneten (2) in den Hohlprofilen (4) durch eine zunächst flüssige und dann aushärtende Substanz fixiert sind.

4. Magnetisierungsvorrichtung (1) nach einem der Ansprüche 1 bis 3, **dadurch gekennzeichnet, dass** der Träger (3) eine Mehrzahl von Aufnahmerohren (5) aufweist und in jedem der Aufnahmerohre (5) ein Hohlprofil (4) zur Aufnahme von mindestens einem der Permanentmagneten (2) ausgebildet ist.

5. Magnetisierungsvorrichtung (1) nach Anspruch 4, **dadurch gekennzeichnet, dass** der Träger (3) wenigstens eine Scheibe (6) als Halterung der Aufnahmerohre (5) umfasst und vorzugsweise in jeder der Scheiben (6) eine Durchführung (7) für das Messrohrs vorgesehen ist.

6. Magnetisierungsvorrichtung (1) nach Anspruch 4 oder 5, **dadurch gekennzeichnet, dass** die Aufnahmerohrlängsachsen parallel zur Messrohrlängsachse ausgerichtet sind.

7. Magnetisierungsvorrichtung (1) nach einem der Ansprüche 4 bis 6, **dadurch gekennzeichnet, dass** wenigstens eines der Aufnahmerohre (5) teilweise aus einem das Magnetfeld beeinflussenden Material besteht, insbesondere aus einem magnetisch gut leitenden Material besteht.

8. Magnetisierungsvorrichtung (1) nach einem der Ansprüche 4 bis 7, **dadurch gekennzeichnet, dass** wenigstens eines der Aufnahmerohre (5) zur Beeinflussung des Magnetfelds um seine Längsachse drehbar im Träger (3) angeordnet ist und gegen die Drehungen fixiert ist.

9. Magnetisierungsvorrichtung (1) nach einem der Ansprüche 1 bis 3, **dadurch gekennzeichnet, dass** der Träger (3) wenigstens einen Profilkörper (11) umfasst, das Querschnittprofil eines jeden der Profilkörper (11) konstant entlang der jeweiligen Profilkörperlängsachse ist und in mindestens einem der Profilkörper (11) wenigstens ein Hohlprofil (4) zur Aufnahme von mindestens einem der Permanentmagneten (2) ausgebildet ist.

10. Magnetisierungsvorrichtung (1) nach Anspruch 9, **dadurch gekennzeichnet, dass** die Profilkörper (11) Extrusionsprofilkörper sind.

11. Magnetisierungsvorrichtung (1) nach Anspruch 9 oder 10, **dadurch gekennzeichnet, dass** die Profilkörperlängsachsen parallel zur Messrohrlängsachse ausgerichtet sind.

12. Magnetisierungsvorrichtung (1) nach einem der Ansprüche 9 bis 11, **dadurch gekennzeichnet, dass** der Träger (3) wenigstens zwei Profilkörper (11) aufweist und jeweils zwei Profilkörper (11) lösbar durch mindestens ein positiv ausgeformtes Verbindungsprofil (12a) am ersten Profilkörper (11) und mindestens ein negativ ausgeformtes Verbindungsprofil (12b) am zweiten Profilkörper (11) verbunden sind und dass das positive Verbindungsprofil (12a) und das negative Verbindungsprofil (12b) derart ausgeformt sind, dass im verbundenen Zustand eine translatorische Bewegung des positiven Verbindungsprofils (12a) und des negativen Verbindungsprofils (12b) zueinander nur entlang einer Achse möglich ist.

13. Magnetisierungsvorrichtung (1) nach einem der Ansprüche 9 bis 12, **dadurch gekennzeichnet, dass** der Träger (3) als Joch zur Führung des von den Permanentmagneten (2) erzeugten magnetischen Rückflusses ausgebildet ist.

14. Magnetisierungsvorrichtung (1) nach einem der Ansprüche 1 bis 12, **dadurch gekennzeichnet, dass** die Permanentmagneten (2) durch den Träger (3) als Halbach-Array angeordnet sind.

15. Magnetisierungsvorrichtung (1) nach einem der Ansprüche 1 bis 14, **dadurch gekennzeichnet, dass** der Träger (3) aus einer Aluminiumlegierung und/oder aus Keramik und/oder aus einem Glasfaserverbundwerkstoff und/oder aus einem Kunststoff besteht.

## Claims

1. Magnetization device (1) for permeation of a multiphase fluid flowing through a measurement tube of a nuclear magnetic flow meter with a magnetic field which is homogenous at least in one plane, with a plurality of permanent magnets (2) for generation of a magnetic field
**characterized in**
**that** the magnetization device (1) has a carrier,
**that** the carrier has a plurality of magnet receivers, each of the magnet receivers accommodates at least one of the permanent magnets (2), the shape of the magnet receivers and of the permanent magnets (2) allows movement of the permanent magnets (2) only in one direction in the magnet receivers, the permanent magnets (2) held by the magnet receivers are arranged by the magnet receivers with reference to the magnetic field, and
**that** the magnet receivers (4) are made as hollow profiles.

2. Magnetization device (1) according to claim 1, **characterized in that** the friction in the movement of the permanent magnets (2) in the hollow profiles (4) is reduced by the lining of the hollow profiles (4).

3. Magnetization device (1) according to claim 1 or 2, **characterized in that** the permanent magnets (2) are fixed in the hollow profiles (4) by a first liquid and then hardening substance.

4. Magnetization device (1) according to any one of claims 1 to 3, **characterized in that** the carrier (3) has a plurality of receiving tubes (5) and a hollow profile (4) for accommodating at least one of the permanent magnets (2) is made in each of the receiving tubes (5).

5. Magnetization device (1) according to claim 4, **characterized in that** the carrier (3) has at least one disk (6) as holder of the receiving tubes (5) and preferably there is a feedthrough (7) for the measurement tube in each of the disks (6).

6. Magnetization device (1) according to claim 4 or 5, **characterized in that** the longitudinal axes of the receiving tubes are aligned parallel to the longitudinal axis of the measurement tube.

7. Magnetization device (1) according to any one of claims 4 to 6, **characterized in that** at least one of the receiving tubes (5) consists partially of a material which influences the magnetic field, especially of a material with good magnetic conductivity.

8. Magnetization device (1) according to any one of claims 4 to 7, **characterized in that** at least one of the receiving tubes (5) is arranged in the carrier (3) with the capacity to turn around its longitudinal axis for influencing the magnetic field and is fixed against rotation.

9. Magnetization device (1) according to any one of claims 1 to 3, **characterized in that** the carrier (3) comprises at least one profile body (11), the cross sectional profile of each of the profile bodies (11) is constant along the respective longitudinal axis of the profile body and in at least one of the profile bodies (11) at least one hollow profile (4) is made to accommodate at least one of the permanent magnets (2).

10. Magnetization device (1) according to claim 9, **characterized in that** the profile bodies (11) are extrusion profile bodies.

11. Magnetization device (1) according to claim 9 or 10, **characterized in that** the longitudinal axes of the profile bodies are aligned parallel to the longitudinal axis of the measurement tube.

12. Magnetization device (1) according to any one of claims 9 to 11, **characterized in that** the carrier (3) comprises at least two profile bodies (11) and each of two profile bodies (11) are detachably connected by at least one positively shaped connecting profile (12a) on the first profile body and at least one negatively shaped connecting profile (12b) on the second profile body and that the positive and the negative connecting profile (12) are shaped such that in the connected state a translational movement of the positive and negative connecting profile (12) to one another is possible only along one axis.

13. Magnetization device (1) according to any one of claims 9 to 12, **characterized in that** the carrier (3) is made as a yoke for guiding the magnetic backflow generated by the permanent magnets (2).

14. Magnetization device (1) according to any one of claims 1 to 12, **characterized in that** the permanent magnets (2) are arranged by the carrier (3) as a Halbach array.

15. Magnetization device (1) according to any one of claims 1 to 114, **characterized in that** the carrier (3) consists of an aluminum alloy and/or ceramic and/or of a glass fiber composite material and/or of a plastic.

## Revendications

1. Dispositif de magnétisation (1) pour la traversée d'un fluide polyphasique s'écoulant à travers un tube de mesure d'un appareil de mesure de débit à noyau magnétique à l'aide d'un champ magnétique homogène au moins dans un plan, comprenant une pluralité d'aimants permanents (2) pour la production du champ magnétique, **caractérisé**
**en ce que** le dispositif de magnétisation (1) présente un support (3),
**en ce que** le support (3) présente une pluralité de logements d'aimants, chacun des logements d'aimants loge une pluralité d'aimants permanents (2), la forme des logements d'aimants et des aimants permanents (2) autorise un mouvement pour le logement des aimants permanents (2) dans les logements d'aimants seulement dans une direction, les aimants permanents (2) logés par les logements d'aimants sont disposés par le biais des logements d'aimants par rapport au champ magnétique et
**en ce que** les logements d'aimants sont réalisés sous forme de profilé creux (4).

2. Dispositif de magnétisation (1) selon la revendication 1, **caractérisé en ce que** la friction lors du mouvement pour le logement des aimants permanents (2) dans les profilés creux (4) est réduite par un revêtement des profilés creux (4).

3. Dispositif de magnétisation (1) selon la revendication 1 ou 2, **caractérisé en ce que** les aimants permanents (2) sont fixés dans les profilés creux (4) par le biais d'une substance tout d'abord liquide puis durcissant.

4. Dispositif de magnétisation (1) selon l'une des revendications 1 à 3, **caractérisé en ce que** le support (3) présente une pluralité de tubes de logement (5) et dans chacun des tubes de logement (5) est réalisé un profilé creux (4) pour le logement d'au moins l'un des aimants permanents (2).

5. Dispositif de magnétisation (1) selon la revendication 4, **caractérisé en ce que** le support (3) comprend au moins un disque (6) comme élément de retenue des tubes de logement (5) et de préférence dans chacun des disques (6) est prévu un passage (7) pour le tube de mesure.

6. Dispositif de magnétisation (1) selon la revendication 4 ou 5, **caractérisé en ce que** les axes longitudinaux de tube de logement sont orientés parallèlement à l'axe longitudinal de tube de mesure.

7. Dispositif de magnétisation (1) selon l'une des revendications 4 à 6, **caractérisé en ce qu'**au moins l'un des tubes de logement (5) est constitué partiellement d'une matière influençant le champ magnétique, en particulier d'une matière bien magnétiquement conductrice.

8. Dispositif de magnétisation (1) selon l'une des revendications 4 à 7, **caractérisé en ce qu'**au moins l'un des tubes de logement (5), pour influencer le champ magnétique, est disposé dans le support (3) de manière rotative autour de son axe longitudinal et est fixé de manière à empêcher les rotations.

9. Dispositif de magnétisation (1) selon l'une des revendications 1 à 3, **caractérisé en ce que** le support (3) comprend au moins un corps de profilé (11), le profil en section transversale de chacun des corps de profilé (11) est constant le long de l'axe longitudinal de corps de profilé respectif et au moins un profilé creux (4) pour le logement d'au moins l'un des aimants permanents (2) est réalisé dans au moins l'un des corps de profilé (11).

10. Dispositif de magnétisation (1) selon la revendication 9, **caractérisé en ce que** les corps de profilé (11) sont des corps de profilé extrudés.

11. Dispositif de magnétisation (1) selon la revendication 9 ou 10, **caractérisé en ce que** les axes longitudinaux de corps de profilé sont orientés parallèlement à l'axe longitudinal de tube de mesure.

12. Dispositif de magnétisation (1) selon l'une des revendications 9 à 11, **caractérisé en ce que** le support (3) présente au moins deux corps de profilé (11) et respectivement deux corps de profilé (11) sont reliés de manière détachable par le biais d'au moins un profilé de liaison (12a) formé positivement sur le premier corps de profilé (11) et d'au moins un profilé de liaison (12b) formé négativement sur le deuxième corps de profilé (11) et **en ce que** le profilé de liaison (12a) positif et le profilé de liaison (12b) négatif sont formés de telle sorte que, dans l'état relié, un mouvement de translation du profilé de liaison (12a) positif et du profilé de liaison (12b) négatif l'un par rapport à l'autre n'est possible que le long d'un axe.

13. Dispositif de magnétisation (1) selon l'une des revendications 9 à 12, **caractérisé en ce que** le support (3) est réalisé sous forme de culasse pour le guidage du reflux magnétique produit par les aimants permanents (2) .

14. Dispositif de magnétisation (1) selon l'une des revendications 1 à 12, **caractérisé en ce que** les aimants permanents (2) sont disposés par le biais du support (3) sous forme de réseau de Halbach.

15. Dispositif de magnétisation (1) selon l'une des revendications 1 à 14, **caractérisé en ce que** le support (3) est constitué d'un alliage d'aluminium et/ou de céramique et/ou d'un matériau composite renforcé par des fibres de verre et/ou d'une matière synthétique.
